# EUROPÄISCHE PATENTANMELDUNG

(11) **EP 0 924 889 A2**
(43) Veröffentlichungstag der Anmeldung: **23.06.1999**
(21) Anmeldenummer: 98440253.7
(22) Anmeldetag: 13.11.1998
(51) Int. Cl.: H04J 14/02, H04B 10/207, H04B 10/16, H04B 10/08

(54) **Zwischenverstärkereinrichtung für ein Ubertragungsnetz**

(30) Priorität: 21.11.1997 DE 19751645
(71) Anmelder: ALCATEL, 75008 Paris (FR)
(72) Erfinder: Grammel, Gert, 73066 Uhingen (DE)
(74) Vertreter: Menzietti, Domenico, Dipl.-Ing

(57) **Zusammenfassung**

Eine Zwischenverstärkereinrichtung (20) mit einer Signalverstärkungsstufe (21) in einem Übertragungsnetz, in welchem Signale von einer Zentralstation (23) über mehrere in Baum-Struktur miteinander verschaltete Übertragungsleitungen mit mehreren gleichartigen Zwischenverstärkereinrichtungen zu mehreren Empfängern (24) übertragen werden können, ist dadurch gekennzeichnet, daß die Zwischenverstärkereinrichtung eine Detektionseinrichtung (22) zum Detektieren einer Störung (28) auf der mit der Zwischenverstärkereinrichtung verbundenen Übertragungsleitung (27), eine Schalteinrichtung (26) zum An- und Abkoppeln der Übertragungsleitung an die bzw. von der Zentralstation sowie ein Verzögerungselement (25) mit Verzögerungszeit tᵢ zum verzögerten Reagieren auf eine von der Detektionseinrichtung (22) festgestellte Störung durch entsprechend verzögertes Betätigen der Schalteinrichtung aufweist. Dadurch sind im Störungsfall nur die letzte Zwischenverstärkereinrichtung vor dem gestörten Leitungsabschnitt sowie eventuell daran anschließende nachfolgende Leitungsteile betroffen, nicht jedoch Netzabschnitte, die ihre Signale nicht über die betroffene Zwischenverstärkereinrichtung erhalten. Außerdem wird die Lokalisierung der aufgetretenen Störung erleichtert.

## Beschreibung

Die Erfindung betrifft eine Zwischenverstärkereinrichtung mit einer Signalverstärkungsstufe in einem Übertragungsnetz, in welchem Signale von einer Zentralstation über mehrere, vorzugsweise in BUS- oder Baum-Struktur miteinander verschaltete Übertragungsleitungen mit mehreren gleichartigen Zwischenverstärkereinrichtungen zu mehreren Empfängern übertragen werden können.

Derartige Zwischenverstärkereinrichtungen sind beispeilsweise aus der DE 44 05 460 C1 bekannt.

In Übertragungsnetzen, beispielsweise in einem CATV (Kabelfernseh-Verteilnetz) mit Baumstruktur werden Signale von einer Zentrale über mehrere Übertragungsleitungen zu verschiedenen End-Empfängern übertragen. Um das Signal von der Kopfstation bis zum letzten Empfänger in ausreichender Signalhöhe weiterleiten zu können, sind, meist äquidistant, teils automatisch geregelte orts- oder ferngespeiste Zwischenverstärker zum Dämpfungsausgleich in das Netz geschaltet, wie beispielsweise in der Zeitschrift "Funkschau" 5/1987, Seiten 46 bis 50 beschrieben ist.

Tritt auf einer der Übertragungsleitungen eine Störung, beispielsweise ein Kurzschluß auf, so ist unsicher, welche Folgen im Netz auftreten. Es kann beispielsweise der der Störungsstelle am nächsten gelegene Zwischenverstärker ausfallen, auch ein Zwischenverstärker an einer weiter entfernten anderen Stelle im Netz. Insbesondere bei der in der DE 44 05 460 C1 beschriebenen baumförmigen Verzweigungsstruktur des Übertragungsnetzes mit Koaxialanschlußleitungen als Punkt_ zuMehrpunkt-Verbindungen zwischen der Zentralstation und vielen am Netz angeschlossenen Teilnehmern kann unter Umständen eine lokale Störung einen größeren Netzteil oder sogar das gesamte Netz lahmlegen. Ferner ist auch eine zentrale Lokalisierung der Störung bei dem bekannten Netz recht schwierig.

Aufgabe der vorliegenden Erfindung ist es demgegenüber, eine Zwischenverstärkereinrichtung der eingangs beschriebenen Art vorzustellen, die bewirkt, daß im Störungsfall nur die letzte Zwischenverstärkereinrichtung vor dem gestörten Leitungsabschnitt sowie eventuell daran anschließende nachfolgende Leitungsteile betroffen sind, nicht jedoch Netzabschnitte, die ihre Signale nicht über die betroffene Zwischenverstärkereinrichtung erhalten. Außerdem soll die Lokalisierung der aufgetretenen Störung erleichtert werden.

Erfindungsgemäß wird diese Aufgabe dadurch gelöst, daß die Zwischenverstärkereinrichtung eine Detektionseinrichtung zum Detektieren einer Störung auf der mit der Zwischenverstärkereinrichtung verbundenen Übertragungsleitung, eine Schalteinrichtung zum An- und Abkoppeln der Übertragungsleitung an die bzw. von der Zentralstation sowie ein Verzögerungselement mit Verzögerungszeit tᵢ zum verzögerten Reagieren auf eine von der Detektionseinrichtung festgestellte Störung durch entsprechend verzögertes Betätigen der Schalteinrichtung aufweist.

Durch das Vorsehen einer Detektionseinrichtung können auftretende Störungen umgehend ermittelt und aufgrund der ermittelnden Detektionseinrichtung auch gleich lokalisiert werden. Durch die Ausstattung der Zwischenverstärkereinrichtung mit einem Verzögerungselement können die unterschiedlichen Zwischenverstärkereinrichtungen mit unterschiedlichen Ansprechzeiten auf eine Störung reagieren. Im Fehlerfall kann dann das betroffene Teil netz abgekoppelt werden, so daß der größtmögliche Netzteil von der Störung unbeeinflußt bleibt.

Besonders bevorzugt ist eine Ausführungsform der erfindungsgemäßen Zwischenverstärkereinrichtung, bei der die Verzögerungszeit tᵢ kleiner ist als die Verzögerungszeit jeder näher an der Zentralstation positionierten Zwischenverstärkereinrichtung und größer als die Verzögerungszeit jeder weiter von der Zentralstation entfernten Zwischenverstärkereinrichtung des Übertragungsnetzes.

Je weiter ein Zwischenverstärker von der Zentralstation entfernt ist, umso kürzer sind die Verzögerungszeiten seines Verzögerungselements. Dadurch wird im Falle einer Störung stets der der Störungsstelle am nächsten gelegene Zwischenverstärker zwischen der Störungsstelle und der Zentralstation abgeschaltet.

Der räumliche Abstand der Zwischenverstärkereinrichtungen voneinander ist unerheblich. Lediglich die Reihenfolge zählt. Insbesondere kann die erfindungsgemäße Zwischenverstärkereinrichtung aufgrund der Art des aktuell vorliegenden Signals (0 oder 1) feststellen, ob die detektierte Störung von einem Netzabschnitt zwischen der Zwischenverstärkereinrichtung und der Zentralstation (Signal = 0) oder von einem Netzabschnitt herrührt, der von der Zentralstation aus gesehen auf die Zwischenverstärkereinrichtung folgt (Signal = 1).

Vorzugsweise ist die Verzögerungszeit tᵢ des Verzögerungselements einer erfindungsgemäßen Zwischenverstärkereinrichtung individuell einstellbar, sodaß Besonderheiten in der Netzstruktur berücksichtigt werden können.

Besonders bevorzugt ist eine Ausführungsform der Erfindung, bei der an die Detektionseinrichtung eine Schaltung angeschlossen ist, die bei Detektieren einer Störung ein Rückmeldungssignal an die Zentralstation abgibt.

Dadurch wird eine zentrale Störungsbearbeitung und -beseitigung ermöglicht.

Bei einer besonders vorteilhaften Weiterbildung dieser Ausführungsform enthält das Rückmeldungssignal eine Kennung der rückmeldenden Zwischenverstärkereinrichtung, so daß in der Zentralstation die Störungsstelle unmittelbar anhand eines Netzplanes lokalisiert werden kann.

Bei einer weiteren vorteilhaften Ausführungsform-kann die Detektionseinrichtung nach der Detektion einer Störung auch deren Wegfall detektieren und gegebenenfalls der Zentralstation rückmelden. Dazu ist es erforderlich, daß die Detektionseinrichtung auch nach dem Auftreten einer Störung in der Lage ist, weiterzuarbeiten und den Verlauf der Störung zu beobachten.

Bei einer Weiterbildung dieser Ausführungsform ist vorgesehen, daß nach Wegfall der Störung die Schalteinrichtung durch ein entsprechendes Signal von der Zentralstation derart betätigt werden kann, daß die abgekoppelte Übertragungsleitung wieder an die Zentralstation angekoppelt wird.

Alternativ dazu kann aber auch an die Detektionseinrichtung eine Schaltung angeschlossen sein, die nach Wegfall der Störung die Schalteinrichtung derart betätigt, daß die abgekoppelte Übertragungsleitung wieder an die Zentralstation angekoppelt wird.

Eine derartige intelligente Schaltung ist heutzutage relativ leicht und preiswert realisierbar; damit kann die Zentralstation bei der Behebung von Störungen durch die dezentrale Automatik erheblich entlastet werden. Zudem wird der Zweig sofort nach der Fehlerbehebung wieder zugeschaltet und muß nicht per Freigabe umständlich und mit Verzögerung wieder in Betrieb genommen werden.

Bei einer Weiterbildung der erfindungsgemäßen Zwischenverstärkereinrichtung kann die Detektionseinrichtung periodisch ein Testsignal auf den von der Störung betroffenen Abschnitt der Übertragungsleitung einspeisen, um zu überprüfen, ob die Störung noch vorliegt. Das Testsignal kann entweder in der Zwischenverstärkereinrichtung selbst erzeugt werden oder von der Zentralstation oder einer anderen an das Übertragungsnetz angeschlossenen Signalquelle abgegeben werden.

Weitere Vorteile der Erfindung ergeben sich aus der Beschreibung und der Zeichnung. Ebenso können die vorstehend genannten und die noch weiter aufgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:
- Fig. 1a: eine schematische Darstellung eines symmetrisch in Baumstruktur aufgebauten Übertragungsnetzes mit erfindungsgemäßen Zwischenverstärkereinrichtungen;
- Fig. 1b: eine asymmetrische Netzstruktur; und
- Fig. 2: ein schematisches Schaltbild einer Ausführungsform der erfindungsgemäßen Zwischenverstärkereinrichtung.

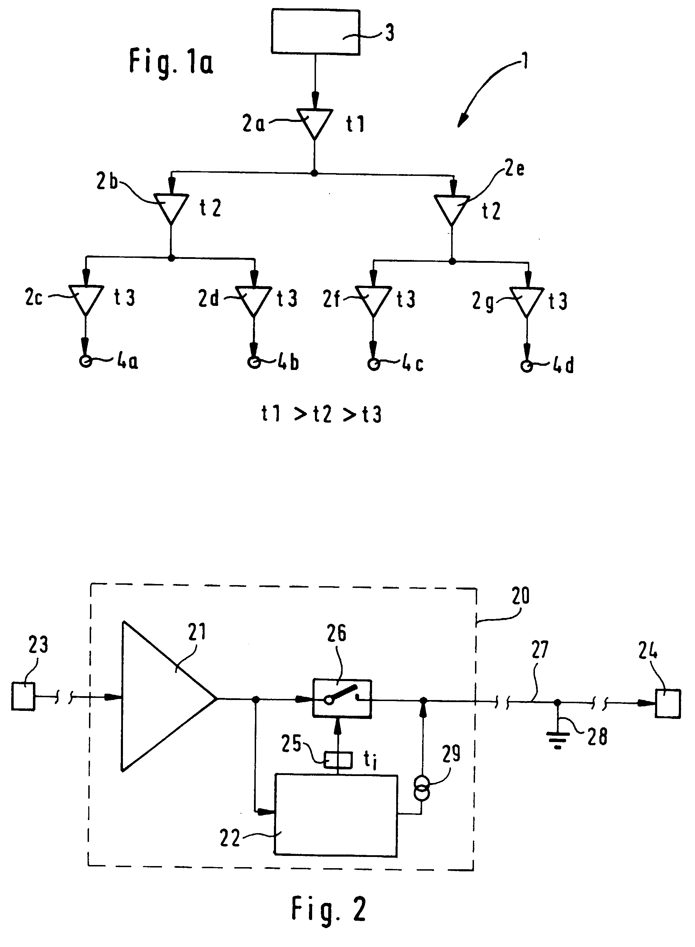

Bei dem in Fig. 1a gezeigten Ausführungsbeispiel werden in einem Übertragungsnetz 1 mit symmetrischer Baumstruktur Signale von einer Zentralstation 3 über gleicharte Zwischenverstärkereinrichtungen 2a bis 2g an mehrere Empfänger 4a bis 4d übertragen.

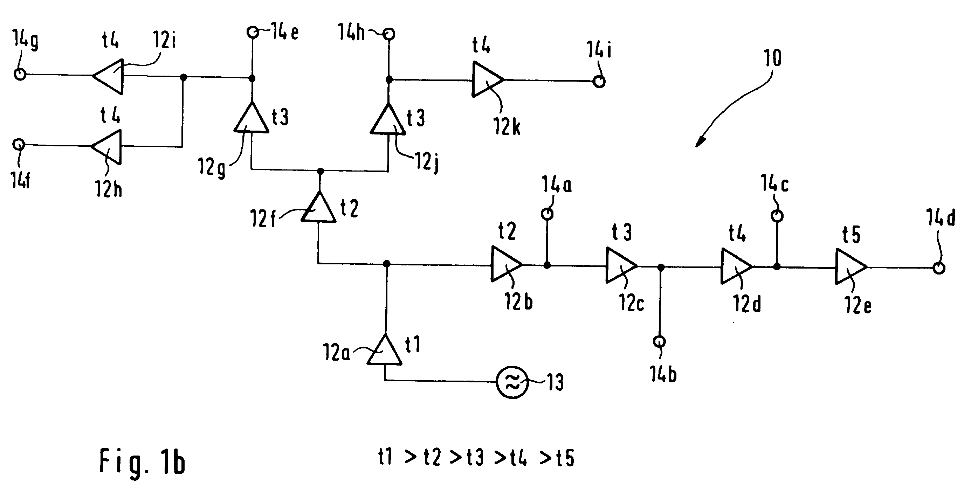

Eine weitere Möglichkeit für eine Punkt-zu-Mehrpunkt-Verbindung ist bei dem in Fig. 1b dargestellten Übertragungsnetz 10 gezeigt. Auch hier wird von einer Zentralstation 13 aus eine Vielzahl von Empfängern 14a bis 14i mit Signalen versorgt, die über mittels Übertragungsleitungen miteinander verschalteten Zwischenverstärkereinrichtungen 12a bis 12k laufen.

In Fig. 2 ist eine Ausführungsform einer erfindungsgemäßen Zwischenverstärkereinrichtung 20, wie sie in den Übertragungsnetzen 1, 10 eingesetzt werden kann, im Detail dargestellt. Neben einer Signalverstärkungsstufe 21 umfaßt die Zwischenverstärkereinrichtung 20 eine Detektionseinrichtung 22 zum Detektieren einer Störung, beispielsweise eines Kurzschlusses 28, auf der mit der Zwischenverstärkereinrichtung 20 verbundenen Übertragungsleitung 27, über welche Signale von der Zentralstation 23 zu einem Endverbraucher 24 transportiert werden sollen.

Wenn die Störung von der Detektionseinrichtung 22 festgestellt wurde, wird mit einer Zeitverzögerung tᵢ über ein Verzögerungselement 25 ein Schalter 26 geöffnet, der die von der Störung betroffene Übertragungsleitung 27 von der Zentralstation 23 abkoppelt. Die Detektionseinrichtung 22 umfaßt eine in der Zeichnung nicht gesondert dargestellte Schaltung, die bei Detektion einer Störung sofort ein Rückmeldungssignal an die Zentralstation 23 abgibt, das die Kennung der Zwischenverstärkereinrichtung 20 enthält.

Um festzustellen, ob die Störung noch vorliegt, gibt die Detektionseinrichtung 22 periodisch ein Testsignal 29 auf den betroffenen Abschnitt der Übertragungsleitung 27 ab. Sobald die Detektionseinrichtung den Wegfall der Störung erkennt, betätigt sie über das Verzögerungselement 25 die Schalteinrichtung 26, um die Übertragungsleitung 27 wieder an die Zentralstation 23 anzukoppeln.

Eine andere Möglichkeit der Störungsbearbeitung besteht darin, daß die periodischen Testsignale und der Befehl zum Ankoppeln des betroffenen Leitungsabschnittes nach Wegfall der Störung direkt von der Zentralstation 23 an die Zwischenverstärkereinrichtung 20 übermittelt werden.

Um sicherzustellen, daß bei einer Störung, beispielsweise einem Kurzschluß 28 auf der Übertragungsleitung 27 nicht das gesamte Übertragungsnetz 1, 10 lahmgelegt wird, sondern lediglich die kleinstmögliche Menge von Netzabschnitten, sind die Verzögerungszeiten tᵢ der Zwischenverstärkereinrichtungen 2a bis 2g bzw. 12a bis 12k derart eingestellt, daß sie mit zunehmendem Abstand von der Zentralstation 3, 13 immer kleiner werden. Dabei können die Verzögerungszeiten tᵢ entweder individuell einstellbar oder je nach Position im Übertragungsnetz 1, 10 fest eingestellt sein.

Im Fehlerfall wird dann lediglich der betroffene Bereich der Schadensstelle von der Zentralstation 3, 13 isoliert, während die übrigen Teile des Übertragungsnetzes 1, 10 unbeeinträchtigt weiterarbeiten können. Falls beispielsweise bei dem in Fig. 1b dargestellten Übertragungsnetz 10 zwischen den Zwischenverstärkereinrichtungen 12d und 12c eine Störung auftritt, so wird aufgrund der gewählten Verzögerungszeiten t₂ > t₃ zunächst die Zwischenverstärkereinrichtung 12c und dann die Zwischenverstärkereinrichtung 12b den nachfolgenden Leitungsabschnitt von der Zentralstation 13 abkoppeln. Die übrigen Netzteile mit den Zwischenverstärkereinrichtungen 12a und 12f bis 12k bleiben von der Störung unbeeinflußt.

Aufgrund der Rückmeldung der Detektion einer Störung von einer der Detektionseinrichtungen an die jeweilige Zentralstation kann die Schadensstelle im Netz unmittelbar eingegrenzt und lokalisiert werden, was Voraussetzung für eine schnelle Behebung der Störung ist.

In den Ausführungsbeispielen sind die Detektionseinrichtung, die Schalteinrichtung und das Verzögerungselement zusammen mit der Signalverstärkerstufe in eine Zwischenverstärkereinrichtung integriert. Es kann alternativ auch ein separates Modul beinhaltend die Detektionseinrichtung, die Schalteinrichtung und das Verzögerungselement vorgesehen sein, das beispielsweise der Signalverstärkerstufe nachgeschaltet, vorgeschaltet oder an einer beliebigen Stelle im Übertragungsnetz plaziert werden kann. Dadurch wird der Einsatz des Moduls unabhängig von der Zwischenverstärkereinrichtung. Somit können auch beispielsweise an einem Verzweigungspunkt im Übertragungsnetz zwei Module zusammen plaziert werden, ein Modul als vorgeschaltetes Modul für den einen Zweig, das andere Modul als vorgeschaltetes Modul für den anderen Zweig, für den Fall, daß sich das Übertragungsnetz am Verzweigungspunkt in zwei Richtungen verzweigt. Verzweigt es sich in mehr als zwei Richtungen können entsprechend viele Module, beispeislweise je ein Modul für jede Richtung zusammen plaziert werden.

## Patentansprüche

1. Zwischenverstärkereinrichtung mit einer Signalverstärkungsstufe (21) in einem Übertragungsnetz (1;10), in welchem Signale von einer Zentralstation (3; 13; 23) über mehrere, vorzugsweise in BUS- oder Baum-Struktur miteinander verschaltete Übertragungsleitungen (27) mit mehreren gleichartigen Zwischenverstärkereinrichtungen (2a - 2g; 12a - 12k) zu mehreren Empfängern (4a - 4d; 14a 14i) übertragen werden können,
**dadurch gekennzeichnet,**
daß die Zwischenverstärkereinrichtung (2a - 2g; 12a - 12k; 20) eine Detektionseinrichtung (22) zum Detektieren einer Störung (28) auf der mit der Zwischenverstärkereinrichtung (20) verbundenen Übertragungsleitung (27), eine Schalteinrichtung (26) zum An- und Abkoppeln der Übertragungsleitung (27) an die bzw. von der Zentralstation (3; 13; 23) sowie ein Verzögerungselement (25) mit Verzögerungszeit tᵢ zum verzögerten Reagieren auf eine von der Detektionseinrichtung (22) festgestellte Störung (28) durch entsprechend verzögertes Betätigen der Schalteinrichtung (26) aufweist.

2. Zwischenverstärkereinrichtung nach Anspruch 1, dadurch gekennzeichnet, daß die Verzögerungszeit tᵢ kleiner ist als die Verzögerungszeit jeder näher an der Zentralstation (3; 13; 23) positionierten Zwischenverstärkereinrichtung und größer als die Verzögerungszeit jeder weiter von der Zentralstation (3; 13; 23) entfernten Zwischenverstärkereinrichtung des Übertragungsnetzes (1; 10).

3. Zwischenverstärkereinrichtung nach einem der vorhergehenden Ansprüche, dadurch gekennzeichnet, daß die Verzögerungszeit tᵢ des Verzögerungselements (25) individuell einstellbar ist.

4. Zwischenverstärkereinrichtung nach einem der vorhergehenden Ansprüche, dadurch gekennzeichnet, daß an die Detektionseinrichtung (22) eine Schaltung angeschlossen ist, die bei Detektieren einer Störung (28) ein Rückmeldungssignal an die Zentralstation (23) abgibt.

5. Zwischenverstärkereinrichtung nach Anspruch 5, dadurch gekennzeichnet, daß das Rückmeldungssignal eine Kennung der rückmeldenden Zwischenverstärkereinrichtung (20) enthält.

6. Zwischenverstärkereinrichtung nach einem der vorhergehenden Ansprüche, dadurch gekennzeichnet, daß die Detektionseinrichtung (22) nach der Detektion einer Störung (28) auch deren Wegfall detektieren und ggf. der Zentralstation (23) rückmelden kann.

7. Zwischenverstärkereinrichtung nach Anspruch 7, dadurch gekennzeichnet, daß nach Wegfall der Störung (28) die Schalteinrichtung (26) durch ein entsprechende Signal von der Zentralstation (23) derart betätigt werden kann, daß die abgekoppelte Übertragungsleitung (27) wieder an die Zentralstation (23) angekoppelt wird.

8. Zwischenverstärkereinrichtung nach Anspruch 7, dadurch gekennzeichnet, daß an die Detektionseinrichtung (22) eine Schaltung angeschlossen ist, die nach Wegfall der Störung (28) automatisch die Schalteinrichtung (26) derart betätigt, daß die abgekoppelte Übertragungsleitung (27) wieder an die Zentralstation (23) angekoppelt wird.

9. Zwischenverstärkereinrichtung nach einem der Ansprüche 7 bis 9, dadurch gekennzeichnet, daß die Detektionseinrichtung (22) zur Detektion des Wegfalls einer Störung (28) periodisch oder dauernd ein Testsignal (29) auf den betroffenen Abschnitt der Übertragungsleitung (27) abgeben kann.

10. Modul, beinhaltend eine Detektionseinrichtung (22) zum Detektieren einer Störung (28) auf einer ersten Übertragungsleitung (27), eine Schalteinrichtung (26) zum An- und Abkoppeln der ersten Übertragungsleitung (27) an eine zweite Übertragungsleitung bzw. von dieser zweiten Übertragungsleitung sowie ein Verzögerungselement (25) mit Verzögerungszeit tᵢ zum verzögerten Reagieren auf eine von der Detektionseinrichtung (22) festgestellte Störung (28) durch entsprechend verzögertes Betätigen der Schalteinrichtung (26).
